# EUROPEAN PATENT APPLICATION

(11) **EP 1 289 013 A1**
(43) Date of publication of application: **05.03.2003**
(21) Application number: 01810786.2
(22) Date of filing: 15.08.2001
(51) Int. Cl.: H01L 23/532

(54) **A method for applying a semiconductor chip to a substrate and an assembly obtained thereby**

(71) Applicant: Datamars SA, 6930 Bedano-Lugano (CH)
(72) Inventor: Oggian, Sileno, 6930 Bedano (CH); Malfanti, Roberto, 6968 Sonvico (CH); Stegmaier, Peter, 6946 Ponte Capriasca (CH)
(74) Representative: AMMANN PATENTANWÄLTE AG BERN AMMANN INGENIEURS-CONSEILS EN PROPRIETE INTELLECTUELLE SA BERNE AMMANN PATENT ATTORNEYS LTD BERNE

(57) **Abstract**

For assembling a semiconductor chip (1-5) and a substrate (10), an electrically conducting layer (6) is applied to each terminal pad (1) of the chip, said layer (6) extending from said pad onto the surface the chip for increasing the contacting surface of each pad. In this way, less precision is required for safely assembling said chip and substrate with the correct electrical connections and for high stability.

## Description

This invention relates to a method according to the preamble of claim 1 and to an assembly obtained thereby according to the preamble of claim 6.
In prior methods and assemblies of this kind, the terminal pads of a chip to be applied to a substrate are covered with suitable material, preferable an electrically conductive adhesive, whereafter the chip is "flipped" onto the substrate with its terminal pads and said conducting material respectively contacting conductors of the substrate. However, the terminal pads of chips are usually very small and at short distance from each other. Therefore, high precision is required when applying the chip onto the substrate in order that all terminal pads are brought into contact with the proper conductor, and only with the same, of the substrate. With this method problems may also be encountered with differences between thermal expansion of the chip and the substrate.

This invention aims in reducing or avoiding the difficulties mentioned above. The solution is defined in the characterising clauses of claims 1 and 6 respectively. By the extension of the area of said terminal pads by a conductive material, the conducting area to bring into contact with a conductor of the substrate may substantially be increased, usually multiplied, whereby less precision is required for warranting correct contacting between terminals of the chip and conductors of the substrate. Preferably a layer of additional non-conductive material is applied on top of the chip passivation layer, except for terminal pad areas. Said conducting material is applied subsequently to said terminal pads and non-conductive material respectively. This layer of additional non-conductive material reduces or avoids problems with differences in thermal expansions of the chip and substrate respectively.
This invention will now be explained in more detail with reference to the accompanying drawing showing, by way of example, an embodiment of the invention.
- Fig. 1: is a top view of a chip, prepared for connection as usual,
- Fig. 2: is a section along line II-II in Fig. 1,
- Fig. 3: is a top view of a chip prepared for connection in accordance with this invention,
- Fig. 4: is a section along line IV-IV in Fig. 3, and
- Fig. 5: is a section along line V - V in Fig. 3.

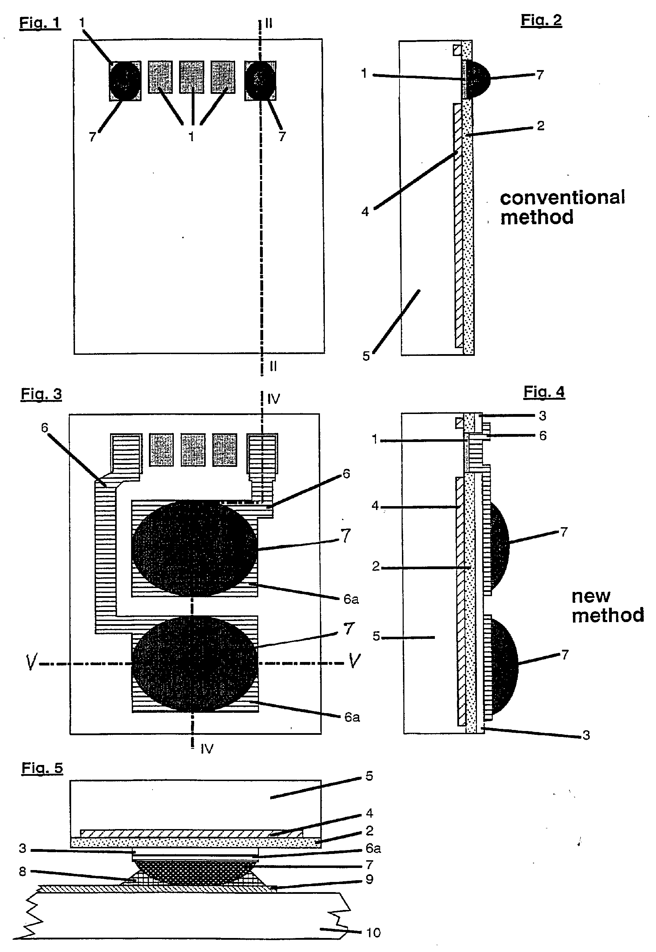

The chip schematically shown in Figs. 1 and 2 has five terminal pads 1 at the upper surface of its wafer base 5. A passivation layer 2 is applied to this upper surface on top of the active elements 4 and except for the pad areas. A bead or layer 7 of an electrically conducting adhesive is applied to the two outer terminal pads 1. In this way the chip is prepared for application to a substrate as set out above. The area contacting the substrate is limited to the area of the pad 1 and the bead 7 respectively, and this area is usually very small. The difficulties and drawbacks of this prior method have been explained above.

Figs. 3 and 4 illustrate a chip prepared for assemblage with a substrate in accordance with this invention. The same reference numerals are used in all Figures for corresponding parts. The passivation layer 2 is coated with a layer of non-conductive material 3. Two terminal pads 1 are covered and contacted by a layer 6 of electrically conductive material, preferably a conducting polymer. Each of these layers 6 extends on the surface of said layer 3 of non-conductive material to an enlarged contacting area 6a. Each of these contacting areas 6a is covered with a bead or layer 7 of electrically conducting connection material. As shown in Fig. 5, each of these beads or layers 7 is brought into contact with a conductor 9 of a substrate 10. The conductor(s) of the substrate 10 may also be provided with a bead or layer 8 of electrically conducting connection material. Preferably connection materials 7 and 8 are interacting and forming a permanent junction after being brought into contact with each other, similar to two-component adhesives.

It is obvious that with the application of conducting material 6 as shown in Fig. 3, the contacting areas of the chip may substantially be enlarged compared with the contacting areas of the terminal pads 1. This simplifies manufacture as explained above, particularly with chips having a limited number of terminal pads or of terminal pads which have to be connected to conductors of the substrate.

As an example, the chip of a transponder has two terminals only for connection of the same to the antenna of the transponder, while three more terminals are used for chip testing purposes only, and not connected for effective chip use in application. Therefore, the assembly according to this invention may preferably be used with transponder manufacture.

The layer 3 of non-conductive material mentioned above should preferably have relatively high elasticity and/or plasticity in order to assist absorption of differences in thermal expansion of the chip and of the substrate.

By the increased surface of the connecting an contacting areas 6a and 7/8 respectively and the possibility of placing these areas substantially symmetrically and in the centre of the chip, the mechanical stability of the assembly may be improved.

## Claims

1. A method for applying and connecting a semiconductor chip to a substrate, wherein according to a flip-chip method, the chip is applied with its terminal pads directed towards the substrate onto the same whereby an electric connection is established between said terminal pads and conductors of said substrate, **characterised in that** the area of said pads is extended by applying conductive material to said pad and chip surface respectively prior to applying said chip to said substrate.

2. The method according to claim 1, wherein said conductive material is a polymer.

3. The method according to claim 1 or 2, , wherein said chip surface is first coated with an additional, non-conductive material on top of the chip passivation layer except for terminal pad areas, whereafter said conductive material is applied.

4. The method of any of claims 1 to 3, wherein beads or layers of conductive connection material, such as conducting adhesive, are applied to areas of said conductive material destined for contacting conductors of said substrate, prior to applying said chip to said substrate.

5. The method of any of claims 1 to 4, wherein a conductive connection material is applied to conductor areas of said substrate destined to contact areas of said conductive material, prior to applying said chip to said substrate.

6. An assembly of a substrate with at least one semiconductor chip (5), wherein terminal pads (1) of said chip are electrically connected to conductors (9) of said substrate (10), wherein said terminal pads (1) are electrically connected to layers (6) of electrically conductive material extending on the surface of said chip (5), said layers (6) serving as a contact area (6a) of a size exceeding the size of said terminal pads (1).

7. An assembly according to claim 6, **characterised by** an insulating coating (3) between said chip surface and said layers (6) of electrically conductive material.

8. An assembly according to claims 6 or 7, comprising beads or pads (7) of electrically conductive adhesive between contact areas (6a) of said chip (1-5) and contact areas (9)of said substrate (10).

9. The use of an assembly according to any of claims 6 to 8 as an electronic equipment of a transponder.
